(19) Europäisches Patentamt

European Patent Office

Office européen des brevets

(11) **EP 1 030 183 B1**

(12) **FASCICULE DE BREVET EUROPEEN**

(45) Date de publication et mention
de la délivrance du brevet:
**29.03.2006 Bulletin 2006/13**

(51) Int Cl.:
***G01R 15/20*** *(2006.01)*      ***G01R 1/07*** *(2006.01)*

(21) Numéro de dépôt: **00400413.1**

(22) Date de dépôt: **14.02.2000**

(54) **Capteur de courant**

Stromsensor

Current sensor

(84) Etats contractants désignés:
**CH DE ES GB IT LI**

(30) Priorité: **17.02.1999 FR 9901907**

(43) Date de publication de la demande:
**23.08.2000 Bulletin 2000/34**

(73) Titulaire: **ABB CONTROL**
**F-69680 Chassieu (FR)**

(72) Inventeur: **Baudoin, Franck**
**69008 Lyon (FR)**

(74) Mandataire: **Laget, Jean-Loup**
**Cabinet LOYER**
**161, rue de Courcelles**
**75017 Paris (FR)**

(56) Documents cités:
**US-A- 4 625 166**

EP 1 030 183 B1

**Description**

La présente invention concerne d'une manière générale un moyen de mesure de courant généralement appelé capteur de courant. Un tel moyen est mis en oeuvre pour mesurer le courant circulant dans un conducteur en un point quelconque dudit conducteur.

De manière usuelle, le fonctionnement des capteurs de courant est basé sur la mise en oeuvre d'un noyau magnétique, muni ou non d'un enroulement secondaire, à travers lequel on mesure un signal reflétant la valeur du courant parcourant le conducteur autour duquel est disposé le capteur de courant. Les capteurs de courant couramment mis en oeuvre dans l'industrie et dans le domaine ferroviaire appartiennent aux techniques dites de boucle ouverte et de boucle fermée.

Ces capteurs de courant à circuit magnétique se présentent la plupart du temps sous la forme d'une couronne fermée ce qui oblige à découper le conducteur dans lequel on doit surveiller le courant pour positionner le capteur autour dudit conducteur. En effet, pour qu'un capteur de courant à circuit magnétique soit performant, il faut que l'entrefer soit réduit, de l'ordre de quelques millimètres, que la section du circuit magnétique soit importante et que la matière du circuit magnétique soit de bonne qualité. De ce fait, un capteur de courant ne peut être performant que si l'entrefer est de valeur très faible, ce qui ne permet pas la réalisation de capteurs géométriquement ouverts, en forme de C.

La nécessité de disposer d'un circuit magnétique à la fois de section importante et en une matière de bonne qualité rend les capteurs de courant à circuits magnétiques très coûteux ce qui limite leur utilisation.

Par ailleurs, les capteurs de courant à circuit magnétique mettant en oeuvre la technologie de boucle fermée nécessitent la présence de dissipateurs de chaleur au niveau de leur partie électronique.

Les capteurs de courant à champ magnétique mettant en oeuvre la technologie en boucle ouverte présentent pour leur part l'inconvénient d'être limités quant à la valeur du courant maximal qu'ils peuvent mesurer du fait d'une saturation du circuit magnétique.

Il est connu du Brevet américain N° 4 625 166 un dispositif destiné à mesurer la différence de potentiel entre deux points d'un matériau soumis à un champ magnétique. Ce dispositif comporte des sondes Hall disposées suivant une courbe reliant lesdits deux points. Lesdites sondes sont disposées de manière à être régulièrement réparties le long de la courbe reliant lesdits deux points et à être proches les unes des autres.
Suivant une variante de réalisation décrite dans ce brevet, la courbe suivant laquelle sont disposées lesdites sondes est une ligne circulaire fermée disposée autour d'un conducteur parcouru par un courant électrique.

Ce dispositif permet de mesurer la valeur du courant circulant dans le conducteur quelle que soit la position de celui-ci au milieu du cercle formé par lesdites sondes.

Un tel montage est complexe et onéreux puisqu'il nécessite la mise en oeuvre d'un grand nombre de sondes, 24 dans la variante représentée, étant donné que celles-ci doivent être proches les unes des autres.

La présente invention se propose donc de fournir un capteur de courant beaucoup moins cher et d'une plus grande facilité d'emploi que les capteurs de courant à circuits magnétiques. Lesdits capteurs ayant de plus, une plus grande plage d'utilisation.

A cet effet, l'invention concerne un capteur de courant destiné à mesurer la valeur du courant circulant dans un conducteur, constitué de composants sensibles au champ magnétique disposés à proximité du conducteur en étant répartis géométriquement autour de celui-ci et d'un circuit de traitement de données prenant en compte le signal de sortie de chacun desdits composants sensibles au champ magnétique afin d'émettre un signal représentatif du courant circulant dans le conducteur, caractérisé en ce que les composants sensibles au champ magnétique sont disposés sur un support destiné à être positionné autour du conducteur et en ce que le circuit de traitement comporte d'une part des éléments prenant en compte les signaux émis par lesdits composants, lesdits éléments ayant un gain déterminé en fonction de la position géométrique des composants par rapport au conducteur, de façon à pondérer lesdits signaux en fonction de la position géométrique des composants par rapport au conducteur, et d'autre part un élément effectuant la somme desdits signaux pondérés et émettant un signal représentatif du courant circulant dans ledit conducteur.

Le capteur de courant selon l'invention est encore remarquable en ce que :

-   le support est ouvert, en forme de C, ou est à structure fermée,

-   il est susceptible de mesurer la valeur du courant circulant dans chacun de plusieurs conducteurs disposés à faible distance les uns des autres,

-   la position et l'orientation de chaque composant sensible au champ magnétique est déterminée par le calcul pour que lesdits composants sensibles au champ magnétique soient influencés par le courant traversant l'un seulement des conducteurs en présence, les courants traversant les autres conducteurs ne les influençant pas,

-   les composants sensibles au champ magnétique sont des sondes à effet Hall,

- les composants sensibles au champ magnétique sont des magnétorésistances.

L'invention sera mieux comprise grâce à la description qui va suivre donnée à titre d'exemple non limitatif en référence aux dessins annexés dans lesquels :

- la figure 1 montre schématiquement un premier capteur de courant selon l'invention,

- les figures 2a et 2b montrent schématiquement deux exemples de réalisation d'un capteur de courant selon la figure 1 dont le support est ouvert,

- les figures 3a et 3b montrent schématiquement deux exemples de réalisation d'un capteur de courant selon la figure 1 dont le support est à structure fermée,

- la figure 4 montre schématiquement une seconde réalisation d'un capteur de courant selon l'invention sous la forme d'un capteur de courant polyphasé,

- les figures 5 et 6 montrent schématiquement deux exemples de réalisation d'un capteur de courant selon la figure 4,

- la figure 7 montre schématiquement le circuit de traitement de données,

- la figure 8 est un schéma géométrique d'un capteur de courant selon l'invention comportant deux composants sensibles au champ magnétique disposés près de deux conducteurs parcourus par un courant électrique,

- les figures 9a et 9b montrent deux exemples de réalisation d'un capteur de courant destiné à mesurer le courant circulant dans un conducteur de section rectangulaire.

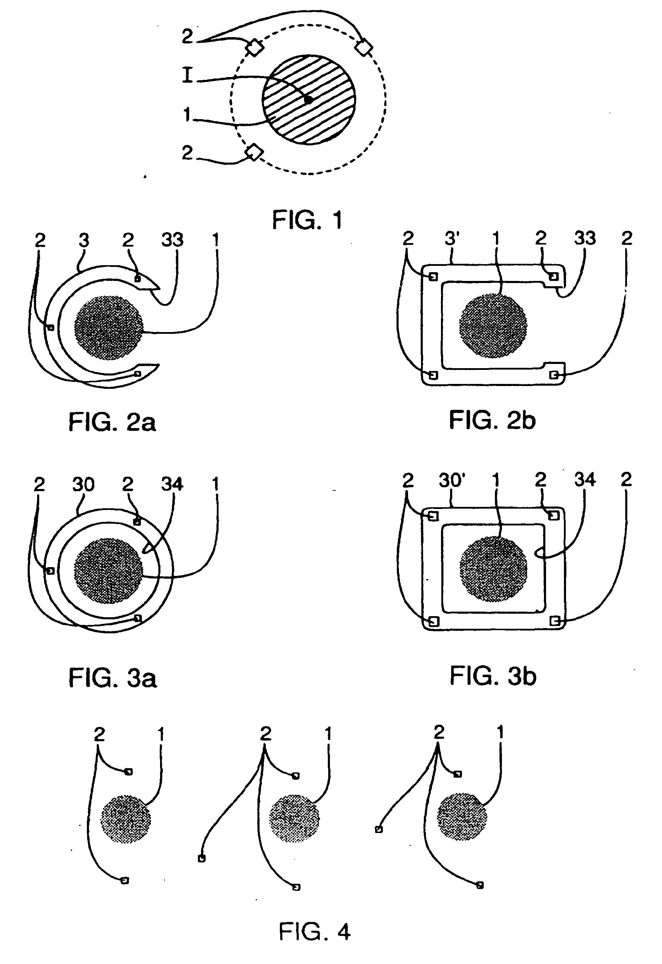

Comme schématisé à la figure 1 l'invention propose de constituer un capteur de courant en disposant des composants 2 sensibles au champ magnétique à proximité du conducteur 1. Le conducteur 1 est vu en section sur les dessins, le courant I le parcourant suivant une direction perpendiculaire à cette section.

De manière connue en soi, un champ magnétique est créé autour d'un conducteur 1 lorsqu'il est parcouru par un courant électrique I. En un point disposé à proximité du conducteur, la valeur de ce champ magnétique est une fonction de la valeur du courant I et de la position géométrique du point étudié par rapport au conducteur.

Dans le capteur de courant selon l'invention, des composants sensibles au champ magnétique, tels que des sondes à effet Hall ou des magnétorésistances, sont disposés à proximité du conducteur 1 étudié. Ces composants émettent un signal représentatif du champ magnétique qu'ils observent à leur point d'implantation.

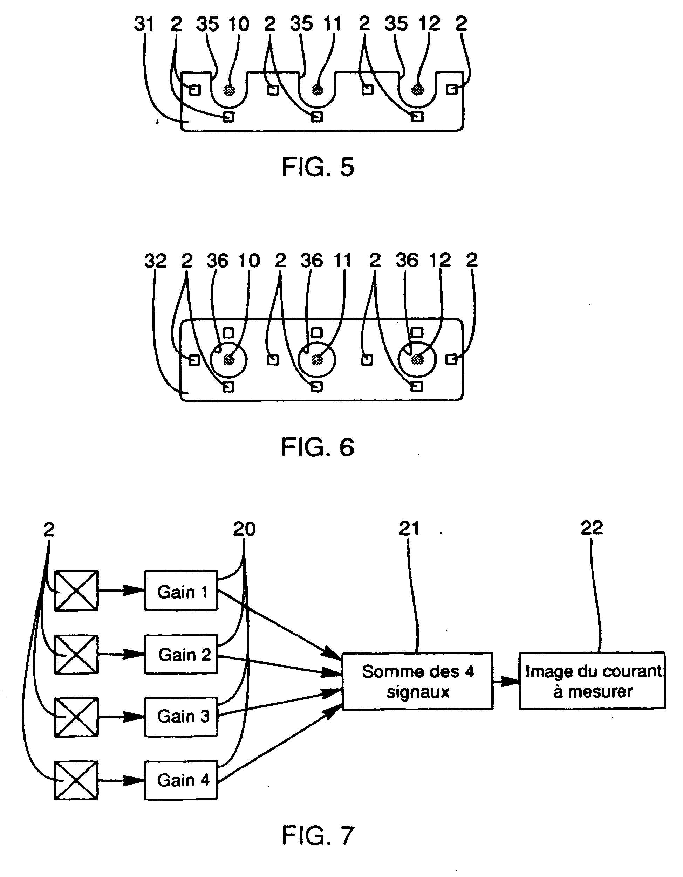

Un circuit de traitement schématisé à la figure 7, prend en compte les signaux émis par les composants 2. Ces signaux sont pondérés lors de leur passage dans des éléments 20 puis on effectue leur somme en 21 afin d'émettre en 22 un signal représentatif de la valeur du courant I circulant dans le conducteur 1.

Le champ magnétique créé lors du passage du courant I dans le conducteur 1 n'est pas uniforme, sa valeur varie en fonction de la position géométrique du point de mesure. Les composants 2 qui sont répartis géométriquement autour du conducteur ne sont donc pas soumis au même champ magnétique. En conséquence, le signal de sortie de chaque composant est pris en compte par le circuit de traitement des données en étant pondéré en fonction de la position géométrique dudit composant par rapport au conducteur 1. Cette pondération est effectuée au niveau des éléments 20 dont le gain est déterminé en fonction de la position géométrique du composant 2 par rapport au conducteur 1.

Dans l'exemple de réalisation représenté à la figure 1, les composants 2 sont disposés sur un cercle entourant concentriquement le conducteur 1, ils pourraient bien entendu être disposés de manière différente.

Le capteur de courant suivant l'invention a pour principal avantage d'être très bon marché du fait qu'il ne comporte pas de noyau magnétique. Il présente de plus un autre avantage qui est celui de ne pas être sujet à échauffement.

Un autre avantage du capteur selon l'invention tient au fait que, dans les conditions normales d'utilisation, le champ magnétique mesuré par les composants sensibles au champ magnétique ne comportant pas de circuit magnétique est faible, le capteur est alors capable de mesurer des surintensités momentanées dans le conducteur sans être détruit. Ceci est dû au fait que les composants sensibles au champ magnétique sont capables de mesurer les champs magnétiques importants engendrés par un courant d'intensité importante circulant dans le conducteur, et que le circuit électronique placé en sortie des composants peut saturer sans se détériorer.

Comme visible aux figures 2a, 2b et 3a, 3b, et de manière à constituer un capteur de courant pratique d'emploi, les composants 2 sensibles au champ magnétique sont disposés sur un support 3, 3', 30, 30' que l'ont peut positionner autour du conducteur 1 à étudier.

Les figures 2a et 2b montrent des supports 3 et 3' ouverts, en forme de C, un tel support est d'utilisation très aisée puisqu'il peut facilement être positionné autour du conducteur 1, en faisant coulisser l'encoche 33 autour dudit conducteur 1. Les dessins joints montrent deux formes de réalisation du support 3, 3' en forme de C ouvert, arrondie pour le support 3 ou plutôt carrée pour le support 3'. Ledit support peut bien entendu prendre toute autre forme géométrique laissant une encoche 33 pour le passage autour du conducteur 1.

Les figures 3a et 3b montrent des supports 30 et 30' de structure générale fermée, le câble étant, lorsque le support 30, 30' est en place, disposé à l'intérieur d'un orifice 34 dudit support. Un tel support peut être réalisé en deux parties que l'on rapproche l'une de l'autre ou sous forme d'une bande dont les extrémités sont raccordées au montage. Comme précédemment, les supports peuvent être de toute forme géométrique, par exemple arrondie comme à la figure 3a ou carrée comme à la figure 3b.

Un autre avantage que présente le capteur de courant à composants sensibles au champ magnétique de l'invention tient au fait qu'il est également susceptible d'être utilisé pour mesurer le courant de chacun de plusieurs conducteurs placés à faible distance les uns des autres, ce qui est difficilement réalisable avec les capteurs de courant connus à circuit magnétique.

Dans un tel cas, des composants 2 sensibles au champ magnétique sont, comme représenté à la figure 4, disposés à proximité des conducteurs, les trois conducteurs 10, 11, 12 par exemple. Chaque composant 2 mesure un champ magnétique dépendant des champs magnétiques créés par chacun des conducteurs à son point d'implantation.

De la même manière que décrit en référence aux figures 2 et 3, il est possible de positionner les composants 2 sur un support ouvert 31 présentant des encoches 35 ou sur un support à structure fermée 32 pour lequel les conducteurs 10, 11, 12 sont disposés dans des orifices 36.

Le circuit de traitement connait la position géométrique de chaque composant 2 par rapport à chaque conducteur 10, 11, 12 et peut résoudre un système d'équations pour déterminer la valeur du courant circulant dans chaque conducteur.

Si l'on prend à titre d'exemple un capteur de courant selon l'invention qui comporte j composants 2 et i (i>1) conducteurs parcourus respectivement par le courant $I_1$, $I_2$, ... $I_i$ En nommant $U_{sj}$ la valeur du signal de sortie du composant j, le système d'équations à résoudre pour déterminer les courants $I_i$ s'écrit :

$$
\begin{cases}
U_{s1} = a_{11}\, I_1 + a_{12}\, I_2 + a_{13}\, I_3 + \ldots\ldots\ldots\ldots + a_{1i}\, I_i \\
U_{s2} = a_{21}\, I_1 + a_{22}\, I_2 + a_{23}\, I_3 + \ldots\ldots\ldots\ldots + a_{2i}\, I_i \\
U_{s3} = a_{31}\, I_1 + a_{32}\, I_2 + a_{33}\, I_3 + \ldots\ldots\ldots\ldots + a_{3i}\, I_i \\
\ldots\ldots \\
\ldots\ldots \\
\ldots\ldots \\
U_{sj} = a_{j1}\, I_1 + a_{j2}\, I_2 + a_{j3}\, I_3 + \ldots\ldots\ldots\ldots\ldots + a_{ji}\, I_i
\end{cases}
$$

où $a_{ji}$ est une constante dépendant de la position géométrique du composant j par rapport au conducteur i parcouru par le courant $I_i$, de l'amplification du signal de sortie du composant, de l'angle entre le vecteur représentant la direction de mesure du composant et le vecteur représentant le champ magnétique créé par le courant circulant dans le conducteur au point occupé par le composant sensible au champ magnétique.

Un calcul matriciel classique qui ne sera pas décrit en détail ici, permet d'exprimer les intensités $I_i$ des courants circulant dans les conducteurs en fonction des mesures $U_{sj}$ sous la forme :

$$\begin{cases} I_1 = b_{11}\, U_{s1} + b_{12}\, U_{s2} + b_{13}\, U_{s3} + \ldots\ldots\ldots + b_{1j}\, U_{sj} \\[6pt] I_2 = b_{21}\, U_{s1} + b_{22}\, U_{s2} + b_{23}\, U_{s3} + \ldots\ldots\ldots + b_{2j}\, U_{sj} \\[6pt] I_3 = b_{31}\, U_{s1} + b_{32}\, U_{s2} + b_{33}\, U_{s3} + \ldots\ldots\ldots + b_{3j}\, U_{sj} \\[3pt] \ldots\ldots \\ \ldots\ldots \\ \ldots\ldots \\[3pt] I_i = b_{i1}\, U_{s1} + b_{i2}\, U_{s2} + b_{i3}\, U_{s3} + \ldots\ldots\ldots + b_{ij}\, U_{sj} \end{cases}$$

Comme on peut le comprendre, à mesure que le nombre de conducteurs et le nombre de composants sensibles au champ magnétique deviennent grands, le nombre d'opérations à réaliser par le circuit de traitement devient très important ce qui augmente le coût du dispositif.

Une autre caractéristique importante de l'invention concerne le choix des positions géométriques des différents composants sensibles au champ magnétique par rapport aux conducteurs parcourus par les courants à mesurer.

Suivant l'invention, les composants sensibles au champ magnétique sont disposés de manière à être influencés par le courant traversant l'un seulement des conducteurs en présence, les courants traversant les autres conducteurs ne les influençant pas. Par cette disposition, certains coefficients utilisés dans le calcul matriciel ci-dessus sont nuls, ce qui réduit le nombre de calculs à effectuer et, en conséquence, le coût du dispositif.

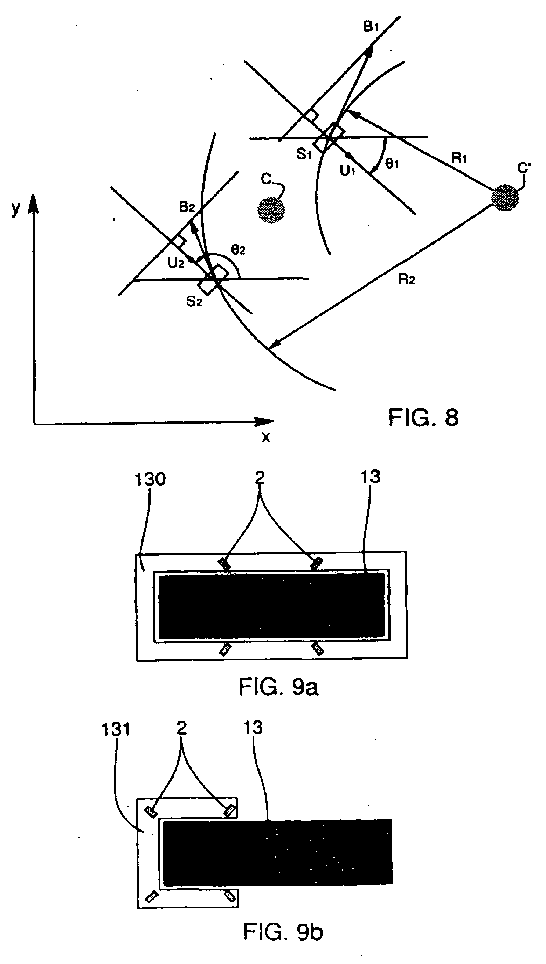

Si l'on se reporte à la figure 8 montrant deux conducteurs C et C' respectivement parcourus par les courantes I et I' et deux composants S1 et S2 disposés de manière à être diamétralement opposés par rapport au conducteur C, on appelle :

- $\vec{B1}$ et $\vec{B2}$ : : les vecteurs représentant le champ magnétique engendré par l'aux points occupés par les composants s1 et s2,

- $\vec{U1}$ et $\vec{U2}$ : : les vecteurs représentant la direction de mesure des composants S1 et S2 également appelés vecteurs unitaire de mesure,
- R1 et R2 : les distances séparant respectivement les composants S1 et S2 du conducteur C',
- $U_{s1}$ et $U_{s2}$ les signaux de sortie des composants S1 et S2 représentant le champ magnétique engendré par le courant I parcourant le conducteur C,
- $U'_{s1}$ et $U'_{s2}$ les signaux de sortie des composants S1 et S2 représentant le champ magnétique engendré par le courant I' parcourant le conducteur C'.

Le courant I parcourant le conducteur C a pour valeur :

$$I = k_{11}\, (U_{s1} + U'_{s1}) + k_{12}\, (U_{s2} + U'_{s2})$$

Pour que le courant I' parcourant le conducteur C' n'ait pas d'influence sur le calcul de I, il faut avoir :

$$k_{12}\, U'_{s2} + k_{11}\, U'_{s1} = 0 \qquad\qquad (1)$$

Cette équation est résolue en calculant $U'_{s1}$ et $U'_{s2}$.

A cet effet, on utilise les coordonnées cartésiennes (x1, y1) du composant S1, (x2, y2) du composant S2 et (x3, y3) du conducteur C' et les angles θ1 et θ2 entre $\vec{U1}$ et $\vec{U2}$ et l'horizontale.

$$R1 = \sqrt{(x3-x1)^2 + (y3-y1)^2} \quad \text{et} \quad R2 = \sqrt{(x3-x2)^2 + (y3-y2)^2}$$

On peut écrire :

En utilisant la théorie de Biot et Savard en S1, on calcule le champ magnétique créé par I'.

$$\vec{B} = \frac{\mu_0}{4\pi} I' \begin{vmatrix} 0 \\ 0 \\ 2 \end{vmatrix} \wedge \begin{vmatrix} \dfrac{x3-x1}{\left(\sqrt{(x3-x1)^2+(y3-y1)^2}\right)^2} \\[3ex] \dfrac{y3-y1}{\left(\sqrt{(x3-x1)^2+(y3-y1)^2}\right)^2} \\[3ex] 0 \end{vmatrix}$$

D'où:

$$\vec{B} = \begin{vmatrix} -\dfrac{\mu_0}{2\pi} I' \dfrac{x3-x1}{\left(\sqrt{(x3-x1)^2+(y3-y1)^2}\right)^2} \\[3ex] \dfrac{\mu_0}{2\pi} I' \dfrac{y3-y1}{\left(\sqrt{(x3-x1)^2+(y3-y1)^2}\right)^2} \\[3ex] 0 \end{vmatrix}$$

La sonde mesure la projection de $\vec{B}$ sur $\vec{U1}$, la valeur de $U'_{s1}$ est alors égale au produit scalaire de $\vec{B}$ par $\vec{U1}$, on obtient donc :

$$U'_{s1} = \cos(\theta_1)\left(-\frac{\mu_0}{2\pi}I'\frac{y3-y1}{\left(\sqrt{(x3-x1)^2+(y3-y1)^2}\right)^2}\right) + \sin(\theta_1)\left(\frac{\mu_0}{2\pi}I'\frac{x3-x1}{\left(\sqrt{(x3-x1)^2+(y3-y1)^2}\right)^2}\right)$$

De même on obtient :

6

$$U'_{s2} = \cos(\theta_2)\left(-\frac{\mu_0}{2\pi}I'\frac{y3-y2}{\left(\sqrt{(x3-x2)^2+(y3-y2)^2}\right)^2}\right) + \sin(\theta_2)\left(\frac{\mu_0}{2\pi}I'\frac{x3-x2}{\left(\sqrt{(x3-x2)^2+(y3-y2)^2}\right)^2}\right)$$

En introduisant ces valeurs de $U'_{s1}$, et $U'_{s2}$ dans l'équation 1, on peut déterminer par un calcul mathématique sur ordinateur l'orientation des composants sensibles au champ magnétique et leur emplacement par rapport au conducteur C'.

A titre d'exemples non limitatifs, le conducteur C ayant pour coordonnées (0 ; 0), on donne ci-après trois configurations pouvant être utilisées :

| | | | |
|---|---|---|---|
| Nombre de composants sensibles : | 2 | 3 | 2 |
| Distance entre les centres des conducteurs : | 15 | 15 | 15 |
| Coordonnées du conducteur C' : | (10,97 ; 10,22) | (9,39 ;-11,69) | (11,18 ; -10) |
| Coordonnées des sondes : | (4 ; 0) | (5 ; 0) | (5 ; 0) |
| | (-4 ; 0) | (-2,5 ; 4,33) | (-5 ; 0) |
| | | (-2,5 ; -4,33) | |
| Angle des sondes (θ) : | -90 ; 90 | -90 ; 30 ; 150 | -90 ; 90 |

On pourra calculer de la même manière les coordonnées et l'angle des sondes devant être mises en place pour pouvoir mesurer la valeur du courant I' parcourant C' sans être influencé par le courant 1 parcourant C.

De même, des calculs permettent de définir les positions géométriques que doivent occuper les sondes d'un capteur de courant destiné à mesurer le courant circulant dans n conducteurs lorsque n est supérieur à 2.

Le capteur de courant selon l'invention peut être utilisé avec tout type de conducteur, quelle que soit sa section.

Les figures 9a et 9b montrent deux exemples de mise en place des composants 2 sensibles au champ magnétique autour d'un conducteur 13 de section rectangulaire. Comme décrit plus haut, les composants 2 sont positionnés sur un support fermé 130, ou ouvert 131, ledit support ouvert présentant des branches plus ou moins longues.

Comme représenté au dessin, les composants 2 peuvent être disposés en tout point de l'entourage du conducteur 13, que ce soit dans une zone centrale comme à la figure 9a ou dans une zone latérale comme à la figure 9b. Ceci permet de constituer des supports ouverts tels que le support 131 qui peuvent être mis en oeuvre avec des conducteurs 13 de dimensions différentes, en étant mis en place sur le côté desdits conducteurs.

## Revendications

1. Capteur de courant destiné à mesurer la valeur du courant (I) circulant dans un conducteur (1, 10, 11, 12), constitué de composants (2) sensibles au champ magnétique destinés à être disposés à proximité du conducteur en étant répartis géométriquement autour de celui-ci et d'un circuit de traitement de données prenant en compte le signal de sortie de chacun desdits composants (2) sensibles au champ magnétique afin d'émettre un signal représentatif du courant circulant dans le conducteur (1, 10, 11, 12), **caractérisé en ce que** les composants (2) sensibles au champ magnétique sont disposés sur un support (3, 3', 30,30', 31, 32) destiné à être positionné autour du conducteur (1, 10, 11, 12) et **en ce que** le circuit de traitement comporte d'une part des éléments (20) prenant en compte les signaux émis par lesdits composants (2), lesdits éléments (20) ayant un gain déterminé en fonction de la position géométrique des composants (2) par rapport au conducteur (1, 10, 11, 12), de façon à pondérer lesdits signaux en fonction de la position géométrique des composants par rapport au conducteur, et d'autre part un élément (21) effectuant la somme desdits signaux pondérés et émettant un signal représentatif du courant circulant dans ledit conducteur.

2. Capteur de courant selon la revendication 1 ou selon la revendication 2, **caractérisé en ce que** le support (3, 3', 31) est ouvert, en forme de C.

3. Capteur de courant selon la revendication 1 ou selon la revendication 2, **caractérisé en ce que** le support (30, 30', 32) est à structure fermée.

7

**4.** Capteur de courant selon l'une quelconque des revendications précédentes, **caractérisé en ce qu'**il est susceptible de mesurer la valeur du courant circulant dans chacun de plusieurs conducteurs (10, 11, 12) disposés à faible distance les uns des autres.

**5.** Capteur de courant selon la revendication 4, **caractérisé en ce que** la position et l'orientation de chaque composant (2) sensible au champ magnétique est déterminée par le calcul pour que lesdits composants sensibles au champ magnétique soient influencés par le courant traversant l'un seulement des conducteurs en présence, les courants traversant les autres conducteurs ne les influençant pas.

**6.** Capteur de courant selon l'une quelconque des revendications 1 à 5, **caractérisé en ce que** les composants (2) sensibles au champ magnétique sont des sondes à effet Hall.

**7.** Capteur de courant selon l'une quelconque des revendication 1 à 5, **caractérisé en ce que** les composants (2) sensibles au champ magnétique sont des magnétorésistances.

**Patentansprüche**

**1.** Stromsensor zum Messen der Stromstärke eines in einem Leiter (1, 10, 11, 12) fließenden Stroms (I), bestehend aus auf das Magnetfeld ansprechenden Komponenten (2), die dazu bestimmt sind, in der Nähe des Leiters und geometrisch um diesen herum verteilt angeordnet zu werden, und aus einer Datenverarbeitungsschaltung, die das Ausgangssignal jeder der auf das Magnetfeld ansprechenden Komponenten (2) verarbeitet, um ein den in dem Leiter (1, 10, 11, 12) fließenden Strom repräsentierendes Signal abzugeben, *dadurch gekennzeichnet,* **dass** die auf das Magnetfeld ansprechenden Komponenten (2) an einem Träger (3, 3', 30, 30', 31, 32) angeordnet sind, der dazu bestimmt ist, um den Leiter (1, 10, 11, 12) herum angeordnet zu werden, und dass die Datenverarbeitungsschaltung einerseits Elemente (20) umfasst, die die von den Komponenten (2) abgegebenen Signale verarbeitet, wobei die Elemente (20) einen Verstärkungsfaktor haben, der in Abhängigkeit von der geometrischen Position der Komponenten (2) bezüglich des Leiters (1, 10, 11, 12) bestimmt ist derart, dass die Signale in Abhängigkeit von der geometrischen Position der Komponenten relativ zum Leiter gewichtet werden, und andererseits ein Element (21) aufweist, welches die Summe der gewichteten Signale bildet und ein den in dem Leiter fließenden Strom repräsentierendes Signal abgibt.

**2.** Stromsensor nach Anspruch 1*, dadurch gekennzeichnet,* **dass** der Träger (3, 3', 31) C-förmig offen ist.

**3.** Stromsensor nach Anspruch 1, *dadurch gekennzeichnet,* **dass** der Träger (30, 30', 32) eine geschlossene Struktur hat.

**4.** Stromsensor nach einem der vorangehenden Ansprüche, *dadurch gekennzeichnet***, dass** er geeignet ist, die Stromstärke des Stroms zu messen, der in jedem von mehreren Leitern (10, 11, 12) fließt, die in geringem Abstand voneinander angeordnet sind.

**5.** Stromsensor nach Anspruch 4, *dadurch gekennzeichnet,* **dass** die Position und Orientierung jeder auf das Magnetfeld ansprechenden Komponente (2) derart festgelegt ist, dass die auf das Magnetfeld ansprechenden Komponenten beeinflusst werden von dem Strom, der nur einen der vorhandenen Leiter durchfließt, während die durch die anderen Leiter fließenden Ströme sie nicht beeinflussen.

**6.** Stromsensor nach einem der Ansprüche 1 bis 5, *dadurch gekennzeichnet,* **dass** die auf das Magnetfeld ansprechenden Komponenten (2) Hall-Effekt-Sensoren sind.

**7.** Stromsensor nach einem der Ansprüche 1 bis 5, *dadurch gekennzeichnet,* **dass** die auf das Magnetfeld ansprechenden Komponenten (2) Magnetowiderstände sind.

**Claims**

**1.** Current sensor which is intended to measure the value of the current (I) circulating in a conductor (1, 10, 11, 12), comprising components (2), which are sensitive to the magnetic field and intended to be disposed near to the conductor by being distributed geometrically around the latter, and a data processing circuit taking into account the output signal of each of said components (2) which are sensitive to the magnetic field in order to emit a signal which is representative of the current circulating in the conductor (1, 10, 11, 12), **characterised in that** the components (2) which are sensitive to the magnetic field are disposed on a support (3, 3', 30, 30', 31, 32) which is intended to be positioned around the conductor (1, 10, 11, 12), and **in that** the processing circuit comprises, on the one hand, elements (20) taking into account the signals emitted by said components (2), said elements (20) having a gain determined as a function of the geometric position of the components (2) relative to the conductor (1, 10, 11, 12) in order to weight said signals as a function of the geometric position of the components relative to the conductor, and, on the other hand, an element (21) effecting the sum of said weighted signals and emitting a signal which is representative of the current circulating in said conductor.

2. Current sensor according to claim 1 or according to claim 2, **characterised in that** the support (3, 3', 31) is open, C-shaped.

3. Current sensor according to claim 1 or according to claim 2, **characterised in that** the support (30, 30', 32) has a closed structure.

4. Current sensor according to any of the preceding claims, **characterised in that** it is able to measure the value of the current circulating in each of a plurality of conductors (10, 11, 12) which are disposed at a small spacing from each other.

5. Current sensor according to claim 4, **characterised in that** the portion and the orientation of each component (2) which is sensitive to the magnetic field is determined by calculation in order that said components which are sensitive to the magnetic field are influenced by the current passing through one only of the conducted which are present, the currents passing through the other conductors not influencing them.

6. Current sensor according to any of the claims 1 to 5, **characterised in that** the components (2) which are sensitive to the magnetic field are Hall effect probes.

7. Current sensor according to any of the claims 1 to 5, **characterised in that** the components (2) which are sensitive to the magnetic field are magnetoresistances.

FIG. 1

FIG. 2a

FIG. 2b

FIG. 3a

FIG. 3b

FIG. 4

FIG. 5

FIG. 6

FIG. 7

FIG. 8

FIG. 9a

FIG. 9b